# EUROPÄISCHE PATENTSCHRIFT

(11) **EP 1 202 326 B1**
(45) Veröffentlichungstag und Bekanntmachung des Hinweises auf die Patenterteilung: **02.01.2004**
(21) Anmeldenummer: 00123714.8
(22) Anmeldetag: 31.10.2000
(51) Int. Cl.: H01L 21/00

(54) **Vorrichtung zur Flüssigkeitsbehandlung von scheibenförmigen Gegenständen**
Apparatus for liquid treatment of wafers-like objects
Dispositif pour le traitement liquide d'objets en forme de plaquettes

(43) Veröffentlichungstag der Anmeldung: 02.05.2002
(60) Teilanmeldung: 03017235.7
(73) Patentinhaber: SEZ AG, 9500 Villach (AT)
(72) Erfinder: Engesser, Philipp, Dipl.-Ing., 88131 Lindau (DE)

(56) Entgegenhaltungen:
- EP-A- 0 444 714
- EP-A- 1 052 682
- US-A- 5 261 965

## Beschreibung

Die Erfindung betrifft eine Vorrichtung und ein Verfahren zur Flüssigkeitsbehandlung eines definierten Bereiches einer Hauptoberfläche eines scheibenförmigen Gegenstandes, insbesondere eines Wafers.

Der Grund für eine Behandlung eines definierten, randnahen Abschnitts eines scheibenförmigen Gegenstandes, insbesondere eines Wafers, soll im folgenden beschrieben werden.

Ein Wafer, beispielsweise ein Siliziumwafer, kann beispielsweise allseitig eine Beschichtung von Siliziumdioxid aufweisen. Für nachfolgende Prozesse (wenn zum Beispiel eine Goldschicht oder eine Schicht aus Polysilizium (polykristallinem Silizium) aufgebracht werden soll) kann es notwendig sein, den Wafer zumindest im Randbereich einer Hauptoberfläche, gegebenenfalls aber auch im Bereich seiner Umfangsfläche und/oder der zweiten Hauptoberfläche von der vorhandenen Beschichtung zu befreien. Dies geschieht durch Ätzverfahren, die sich vor allem in Trockenätzverfahren und Nassätzverfahren untergliedern lassen. Auch kann es erwünscht sein, ein zuvor galvanisch aufgebrachtes Metall (z.B. Kupfer) von bestimmten Bereichen einer Hauptoberfläche eines Halbleitersubstrates zu entfernen. In diesem Fall kann dieser Bereich entweder ein ringförmiger, randnaher Abschnitt sein, oder genau der Bereich der vorderen Hauptoberfläche (Hauptoberfläche auf der sich die Strukturen befinden = device side), in dem sich keine Strukturen befinden, d.h. der chipfreien Zone.

Eine weitere Anwendung ist die Reinigung von Wafern. Hier kann es notwendig sein, den Wafer zumindest im Randbereich einer Hauptoberfläche, gegebenenfalls aber auch im Bereich seiner Umfangsfläche und/oder der zweiten Hauptoberfläche zu reinigen, d.h. von Partikeln und/oder anderen Kontaminationen zu befreien. Dies geschieht durch Nassreinigungsverfahren.

Eine weitere Flüssigkeitsbehandlung ist das Aufbringen von Schichten wie z.B. das galvanische Auftragen von Metallen (Electro-Plating). Dies kann mit oder ohne Strom geschehen, wobei man im letzteren Fall vom "Electroless Electroplating" spricht.

Die Erfindung ist auf das Nassätzen, Nassreinigen oder nasschemische Auftragen von Schichten (zusammengefasst unter dem Begriff Flüssigkeitsbehandlung) gerichtet. Dabei wird der zu behandelnde Flächenabschnitt des Wafers mit der Behandlungsflüssigkeit benetzt und die zu entfernende Schicht bzw. die Verunreinigungen abgetragen oder in diesem Flächenabschnitt eine Schicht aufgebracht.

Während der Flüssigkeitsbehandlung kann der scheibenförmige Gegenstand entweder still stehen oder rotieren (z.B. um seine Achse).

Um zu verhindern, dass die Behandlungsflüssigkeit unkontrolliert auf die nicht zu behandelnde Oberfläche gelangt, wird in der EP 0 316 296 B1 ein Träger (Chuck) vorgeschlagen, der die nicht zu behandelnde, dem Träger zugewandte Oberfläche mit einem Gas spült. Dabei tritt das Gas zwischen der Waferkante und dem Träger aus.

Die JP 09-181026 A beschreibt einen Träger für Halbleiterscheiben der außerhalb einer Ringdüse eine besondere Form, z.B. eine ringförmige, nach außen hin abfallende Stufe oder eine Abschrägung seines Randes, aufweist. Auch wird eine Einsaugöffnung vorgeschlagen. Durch diese Formgebung bzw. die Einsaugöffnung soll die Strömungsgeschwindigkeit im Randbereich beeinflußt (verringert) werden. Dies soll dazu dienen, daß die von oben aufgebrachte Behandlungsflüssigkeit über den Rand des Wafers hinaus auf die dem Chuck zugewandte Seite fließt und dort einen Randbereich behandelt.

Unabhängig davon, ob nun eine Einrichtung zur Aufnahme des scheibenförmigen Gegenstandes (Träger bzw. Chuck) nach EP 0 316 296 B1 oder JP 09-181026 A (englisches Abstract) verwendet wird, kann auf der dem Träger zugewandten Hauptoberfläche maximal ein Randbereich von 1,5 mm (gemessen vom äußeren Rand des Wafers) behandelt werden. Die Flüssigkeit fließt danach wieder in Richtung Waferkante und wird von dieser abgeschleudert. Dieser behandelte Randbereich ist in keinem der beiden Fälle bewußt definiert, vielmehr ist es ein Zufallsergebnis, da die Größe des Randbereiches wesentlich von einer Vielzahl von teilweise einander gegenseitig beeinflussenden Parametern abhängt, wie z.B. Oberflächenbeschaffenheit (Rauhigkeit, Art und Dicke der Adsorptionsschichten), Temperatur, Druck, Luftfeuchtigkeit, etc.

In der US 4,838,289 A wird ein System zum Randätzen eines Wafers beschrieben, bei dem eine Düse gegen den zu ätzenden Bereich der Waferoberfläche gerichtet ist, während der Wafer rotiert. Nachteil dieses Systems ist es, dass der zu behandelnde Bereich nicht genau definiert ist und auch Flüssigkeit auf den Bereich der nicht behandelt werden soll gelangen kann.

In der EP1052682A, die unter Artikel 54(3)EPÜ fällt, wird eine Vorrichtung und ein Verfahren zur Flüssigskeitsbehandlung eines definierten Abschnitts eines scheibenformigen Gegenstandes beschrieben. Außerdem wird in der EPO0444714A eine Vorrichtung zur Flüssigkeits behandlung der Oberseite eines Wafers beschrieben, ohne daß die untere Seite des Wafers mit Flüssigkeit benetzt wird. Dementsprechend liegt nun der Erfindung die Aufgabe zugrunde, eine Möglichkeit aufzuzeigen, auf einer Oberfläche eines scheibenförmigen Gegenstandes einen definierten Abschnitt mit einer Flüssigkeit zu behandeln, wobei es u.a. auch möglich sein soll einen Randbereich von über 2 mm (gemessen vom äußeren Rand des scheibenförmigen Gegenstandes) zu behandeln. Bei diesem definierten Abschnitt kann es sich auch um einen innen liegenden Bereich einer Oberfläche des scheibenförmigen Gegenstandes handeln, d.h. ein Bereich, der nicht bis zum Rand des scheibenförmigen Gegenstandes reicht. Wenn auch hier jeweils ein Bereich der von einer Kreislinie nach außen und/oder innen begrenzt ist, so ist dies dennoch nicht notwendig; der zu behandelnde Bereich kann auch z.B. durch ein Vieleck begrenzt sein. Diese Begrenzungslinie kann, wenn es sich bei dem scheibenförmigen Gegenstand um einen Halbleiterwafer handelt, dem Bereich der Oberfläche auf dem sich die Chips befinden ("device area") entsprechen. Demzufolge ist entweder der innere Chip-Bereich oder der äußere, chip-freie Bereich zu behandeln.

Danach schlägt die Erfindung eine Vorrichtung zur Flüssigkeitsbehandlung eines definierten Abschnitts eines scheibenförmigen Gegenstandes gemäß Anspruch 1 vor, sowie ein Verfahren zur Flüssigkeitsbehandlung eines definierten Abschnitts eines scheibenförmigen Gegenstandes gemäß Anspruch 13.

Haltemittel zum Halten des scheibenförmigen Gegenstandes können unter anderem sein, Vakuumgreifer, Greifmittel, die den scheibenförmigen Gegenstand an seinem umfangsseitigen Rand berühren oder ein sogenannter Bernoulli-Chuck.

Die Maske ist so ausgestaltet, dass diese, wenn sich ein scheibenförmiger Gegenstand (Wafer) auf dem Träger befindet, den scheibenförmigen Gegenstand (Wafer) nicht berührt, d.h. zwischen dem Wafer und der Maske ein Spalt bleibt. Die Maske normal auf die Hauptoberfläche des Wafers projiziert gibt den Bereich des Wafers an, der mit der Flüssigkeit behandelt wird. Das Material der Oberfläche der Maske, die dem scheibenförmigen Gegenstand zugewandt ist, ist so auszuwählen, dass es von der Flüssigkeit so gut benetzt wird, dass Flüssigkeit in den Spalt zwischen scheibenförmigem Gegenstand und Maske durch Kapillarkraft gehalten wird. Die Summe der beiden Benetzungswinkel der Flüssigkeit einerseits gegen den scheibenförmigen Gegenstand und andererseits gegen die Maske sollte kleiner als 180° sein, vorzugsweise kleiner 150°. Bei vorher ausgewählter Maskenoberfläche kann dies selbstverständlich auch durch der Flüssigkeit zugefügte Additive (Netzmittel) erreicht werden.

Ein Vorteil der erfindungsgemäßen Vorrichtung ist es, dass der zu behandelnde Gegenstand genau in dem zu behandelnden Bereich von der Behandlungsflüssigkeit benetzt wird und zwar ohne dass dieser Bereich von einem festen Körper berührt wird. Gleichzeitig wird vermieden, dass Flüssigkeitströpfchen auf Bereiche gelangen, die nicht behandelt werden sollen bzw. dürfen.

Bei einer vorteilhaften Ausführungsform besitzt die Maske die Form eines Ringes. Der Ring kann in diesem Fall einen Innendurchmesser besitzen, der kleiner ist als der Außendurchmesser des scheibenförmigen Gegenstandes, und einen Außendurchmesser, der mindestens gleich groß ist wie der Außendurchmesser des scheibenförmigen Gegenstandes. Dies ist dann notwendig, wenn die zu behandelnde Fläche ebenfalls die Form eines Ringes aufweist, wie dies z.B. beim Entfernen einer Schicht von einem definierten Randbereich eines Halbleiterwafers der Fall ist.

Vorteilhaft ist, wenn die Distanzmittel die Maske und den scheibenförmigen Gegenstand in einem Abstand von 0,05 bis 1 mm zueinander halten. Bei der Verwendung von dünnflüssigen Medien wie Wasser, Lösungsmittel oder diverse Säuren in wässriger Lösung, wird dadurch verhindert, dass die Flüssigkeit leicht aus dem Kapillarbereich zwischen Maske und scheibenförmigen Gegenstand herausrinnt.

Bei einer Ausführungsform besteht das Distanzmittel aus Greifelementen, die in direktem Kontakt mit dem scheibenförmigen Gegenstand sind und direkt oder indirekt mit der Maske verbunden sind. Dies kann z.B. durch ein außen liegendes Gestänge (indirekt) oder durch z.B. umfangsseitig angeordnete Stifte (direkt) erfolgen.

Bei einer weiteren Ausführungsform sind Maske und Haltemittel relativ zueinander bezüglich einer Rotation um eine senkrecht auf die Maske stehende Achse unbeweglich. Maske und Haltemittel rotieren also beide nicht oder rotiert z.B. das Haltemittel, und mit ihm der scheibenförmige Gegenstand, so rotiert die Maske mit der selben Geschwindigkeit mit. Die fehlende Relativbewegung der Maske zur Oberfläche des scheibenförmigen Gegenstandes ist von Vorteil, wenn die im Kapillarbereich zwischen Maske und scheibenförmigen Gegenstand gehaltene Flüssigkeit, während dem sie in diesem Bereich gehalten wird, möglichst wenig Bewegung in sich erfahren soll. Dadurch wird verhindert, in den Bereich der von der Flüssigkeit nicht behandelt werden soll gelangt.

Das Distanzmittel kann aus einer Gaszuführeinrichtung bestehen, die direkt oder indirekt mit der Maske verbunden ist und gegen den scheibenförmigen Gegenstand gerichtet ist, wodurch der scheibenförmigen Gegenstand auf einem Gaspolster gehalten werden kann. Diese Gaszuführeinrichtung kann z.B. eine oder mehrere senkrecht oder schräg zur Oberfläche des scheibenförmigen Gegenstand angeordnete Düsen oder eine Ringdüse sein. Durch Wahl des Drucks bzw. des Gas-Volumenstroms kann bei vorgegebener Form, Größe und Anordnung der Gaszuführeinrichtung der Abstand zwischen der Gaszuführeinrichtung und dem scheibenförmigen Gegenstand und somit der Abstand zwischen Maske und scheibenförmigen Gegenstand exakt und reproduzierbar eingestellt werden.

Die erfindungsgemäße Vorrichtung weist Distanzveränderungsmittel auf, die den Abstand zwischen der Maske und dem scheibenförmigen Gegenstand zueinander so vergrößern können, dass Flüssigkeit, die sich zwischen Maske und scheibenförmigen Gegenstand befindet nicht mehr durch Kapillarkräfte gehalten wird. Dabei kann es sich um einen Bewegungsmechanismus handeln, der die Maske entsprechend bewegen kann. Es kann aber auch der scheibenförmige Gegenstand direkt entsprechend bewegt werden. Ein Distanzveränderungsmittel kann z.B. ein zusätzlichen Greifer geschehen (z.B. Löffel) oder es sind Stifte (Liftingpins) die den scheibenförmigen Gegenstand anheben. Auch kann das Distanzveränderungsmittel eine Gaszuführeinrichtung sein deren Betriebszustand derart geändert werden kann, dass der scheibenförmige Gegenstand angehoben oder gesenkt wird.

Durch ein derartiges Distanzveränderungsmittel werden Maske und scheibenförmiger Gegenstand so weit von einander entfernt, dass Flüssigkeit die sich im Bereich dazwischen befunden hat wieder entfernt werden kann. Von Vorteil ist es, wenn das Distanzveränderungsmittel den Abstand um mindestens 0,2 mm, vorzugsweise mindestens 0,5 mm vergrößern kann.

Vorteilhaft ist es wenn die Distanzveränderungsmittel derart ausgestaltet sind, dass diese den Abstand zwischen der Maske und dem scheibenförmigen Gegenstand während oder unmittelbar nach der Flüssigkeitsbehandlung verändern können. Dies ist z.B. im Fall der Gaszuführeinrichtung als Distanzveränderungsmittel möglich.

Bei einer Ausführungsform sind im wesentlichen senkrecht zu einer Hauptoberfläche des scheibenförmigen Gegenstandes, die Position des scheibenförmigen Gegenstandes umfangsseitig begrenzende Führungselementen angeordnet. Dadurch wird die Position des scheibenförmigen Gegenstandes gegen die Maske bezüglich einer Verschiebung fixiert. Der Abstand der Führungselemente zum Mittelpunkt des scheibenförmigen Gegenstandes kann veränderlich sein.

Auch kann dieser Abstand auf ein so kleines Maß verringerbar sein, dass die Führungselemente den scheibenförmigen Gegenstand festhalten können, und insofern auch Element des Haltemittel sind. Das Haltemittel kann auch sowohl aus Führungselementen als auch einer Gaszuführeinrichtung bestehen.

Das Distanzveränderungsmittel kann aus einer Gaszuführeinrichtung bestehen, die direkt oder indirekt mit der Maske verbunden ist und gegen eine Hauptoberfläche des Gegenstandes gerichtet ist, wodurch der scheibenförmigen Gegenstand auf einem Gaspolster gehalten werden kann. Dabei kann das Distanzmittel eine einfache mechanische Auflage sein (z.B. Stifte, Distanzring) und die Gaszuführeinrichtung nur dann Gas führen, wenn der scheibenförmige Gegenstand angehoben wird.

Bei Distanzmittel und Distanzveränderungsmittel kann es sich auch um zwei Gaszuführeinrichtungen handeln die getrennt von einander ansteuerbar sind.

Bei einer Ausführungsform können die Haltemittel in Rotation versetzt werden, wodurch der scheibenförmige Gegenstand rotiert. Dies ist, wenn auch nicht notwendig, so doch vorteilhaft, da die Behandlungsflüssigkeit sowohl vom Träger als auch von der Waferkante abgeschleudert werden kann.

Der Spalt zwischen der Maske und dem scheibenförmigen Gegenstand beträgt in einer Ausführungsform 0,05 bis 1 mm, vorteilhafterweise 0,1 bis 0,5 mm. Dadurch bildet sich zwischen dem Wafer und der Gasleitvorrichtung eine Art Kapillare aus, von der Flüssigkeit, die um die Waferkante geflossen ist, angesaugt wird. Der Innendurchmesser, der von der Flüssigkeit benetzten, der Gasleitvorrichtung zugewandten Oberfläche ist kleiner als der Innendurchmesser der Ringfläche der Gasleitvorrichtung.

Es ist von Vorteil, wenn die dem scheibenförmigen Gegenstand zugewandte Fläche der Gasleitvorrichtung zu den Hauptoberflächen des scheibenförmigen Gegenstand parallel ist. Der Spalt zwischen dem scheibenförmigen Gegenstand (Wafer) und der Gasleitvorrichtung ist dadurch im gesamten Randbereich gleich groß.

Eine Ausführungsform sieht vor, daß der Träger in Rotation versetzt werden kann. Dies ist, wenn auch nicht notwendig, so doch vorteilhaft, da die Behandlungsflüssigkeit sowohl vom Träger als auch von der Waferkante abgeschleudert werden kann. Ist der Träger während der Flüssigkeitsbehandlung nicht in Rotation, so kann die Flüssigkeit durch einen Gasstrom (aus einer Gaszuführeinrichtung) abgeblasen werden.

Die Vorrichtung kann zusätzlich eine Flüssigkeitsleitung, die auf die der Maske zugewandte Oberfläche des scheibenförmigen Gegenstandes gerichtet ist, aufweisen. Dadurch kann die Oberfläche, deren definierter erster Bereich mit einer ersten Flüssigkeit behandelt worden ist, auch mit einer zweiten Flüssigkeit behandelt werden und zwar in einem zweiten Bereich der vom ersten verschieden ist. Dieser zweite Bereich kann flächenmäßig größer sein und auch den ersten Bereich vollkommen überdecken. Ist die erste Flüssigkeit z.B. eine Ätzflüssigkeit so kann diese mit Hilfe der zweiten Flüssigkeit (z.B. entionisiertes Wasser) restlos von der der Maske zugewandten Oberfläche entfernen. Gleichzeitig kann dadurch auch die Maske gereinigt bzw. von der ersten Flüssigkeit befreit werden.

Weitere Einzelheiten, Merkmale und Vorteile der Erfindung ergeben sich aus der nachstehenden Beschreibung der in den Zeichnungen gezeigten Ausführungsbeispiele der Erfindung.

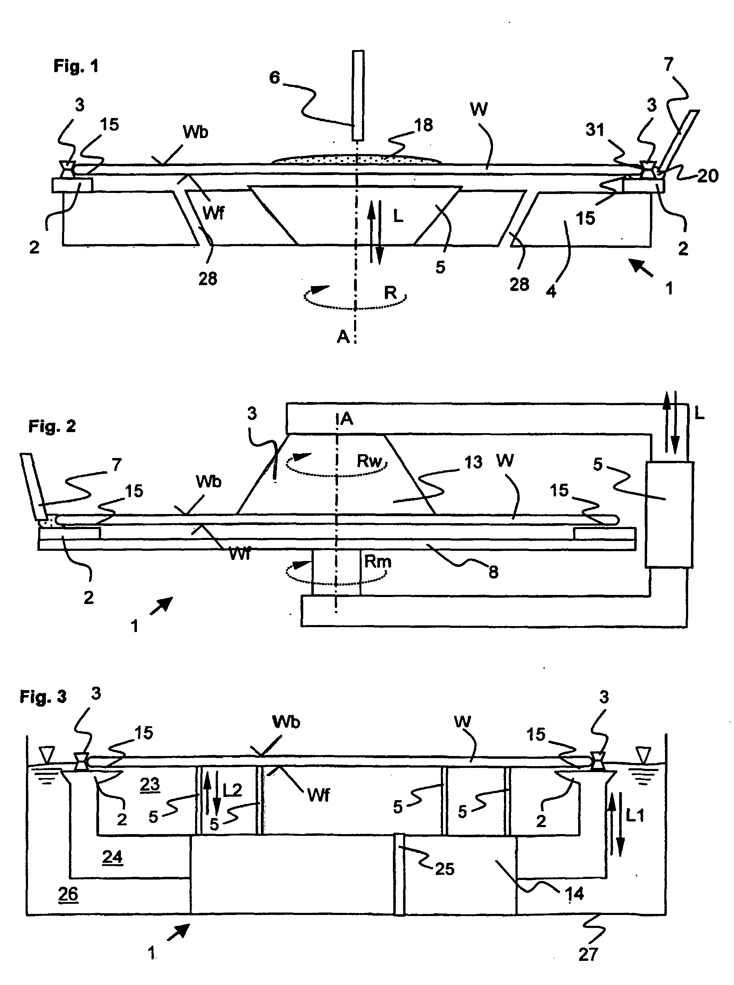

Es zeigt Fig. 1 und 3-5 schematisch Achsialschnitte 5 verschiedener erfindungsgemäßer Ausführungsformen.

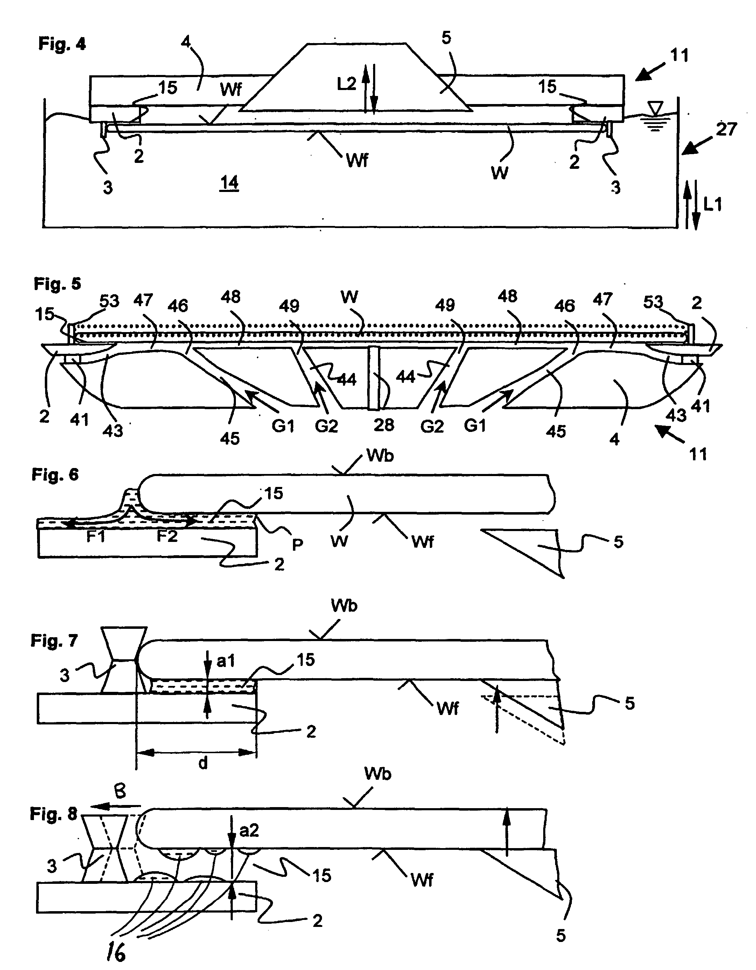

Figur 2 zeigt eine Vorrichtung, die nicht im Rahmen der Erfindung liegt. Die Fig. 6-8 zeigen einen schematischen Achsialschnitt einer Ausführungsform nach Fig. 1 in verschiedenen Betriebszuständen.

Fig. 1 zeigt eine Ausführungsform der erfindungsgemäßen Vorrichtung 1. Die Vorrichtung 1 besteht aus einem im wesentlichen runden Grundkörper 4 auf den die Maske 2, die hier die Form eines Ringes besitzt, konzentrisch angebracht ist. Der Ring 2 kann aber auch aus dem Grundkörper herausgearbeitet sein. Der Ring 2 besitzt einen Außendurchmesser der größer und einen Innendurchmesser der kleiner ist als der Außendurchmesser des Wafers. Stifte 3, die auf dem Ring 4 angebracht sind, halten den Wafer W umfangsseitig. Die Stifte 3 besitzen eine Kerbe 31 die in den Waferrand einrastet und so den Wafer in einer definierten horizontalen Lage halten. Die Stifte 3 mit ihren Kerben 31 stellen insofern die Distanzmittel zur Maske 2 dar. Zwischen der Maske 2 und der der Maske zugewandten Waferoberfläche Wf stellt sich dadurch ein definierter Spalt 15 ein. Die Stifte 3 werden über einen nicht dargestellten Mechanismus relativ zur Achse A bewegt, um den Wafer fest zu greifen und zum Entnehmen oder zum Anheben des Wafers diesen wieder freizugeben. Innerhalb des Grundkörpers 4 ist ein Hebemechanismus 5 (Distanzveränderungsmittel) angeordnet, der in Pfeilrichtung L auf und ab bewegt werden kann, und insofern den Abstand zwischen dem Wafer W und der Maske 2 verändern kann. Der Hebemechanismus besteht aus einem Träger, der eine dem Wafer zugewandte im wesentlichen ebene und zum Wafer parallel Fläche besitzt, die wenn der Träger angehoben wird erst den Wafer an seiner unteren Oberfläche Wf berührt und dann den Wafer anhebt. Die gesamt Vorrichtung 1, und mit ihr der Wafer, kann um die Waferachse A rotieren.

Die Behandlungsflüssigkeit kann entweder durch die außerhalb in der Nähe des Waferrandes angebrachte Düse 7 oder durch eine Düse 6 aufgebracht werden, die gegen die der Maske 2 abgewandte Waferoberfläche Wb gerichtet ist. Im ersten Fall (Düse 7) wird eine Flüssigkeitsmenge 20 unmittelbar beim Waferrand auf die Maske 2 aufgebracht. Die Flüssigkeit wird sodann von dem kapillarartigen Spalt 15 eingezogen und benetzt so genau den Bereich der der Maske 2 zugeordneten Waferoberfläche Wf, der von der Maske 2 überlappt wird. Im zweiten Fall (Düse 6) wird die Flüssigkeitsmenge 18 auf die der Maske 2 abgewandte Oberfläche Wf z.B. in deren Zentrum aufgetragen, die Flüssigkeit rinnt sodann radial nach außen zum Waferrand, was durch Rotation des Wafers unterstützt werden kann. Daraufhin fließt die Flüssigkeit um den Waferrand und wird vom Spalt 15 eingezogen. In beiden Fällen kann der Wafer während der gesamten Flüssigkeitsbehandlung rotieren (R), was den Vorteil hat, dass überschüssige Flüssigkeit, die nicht in den Spalt 15 eindringt, nicht unkontrolliert über die Maske 2 nach unten abfließt, sondern kontrolliert abgeschleudert wird. Anschließend wird auf die der Maske 2 zugewandte Waferoberfläche Wf eine zweite Flüssigkeit (z.B. deionisiertes Wasser) über die Flüssigkeitsleitung 28 aufgebracht, gleichzeitig rotiert der Täger 4, wodurch die zweite Flüssigkeit die Füssigkeit die sich im Spalt 15 befindet verdrängt. Gleichzeitig, davor oder auch danach wird der Wafer mit dem Hebemechanismus 5 angehoben.

Fig. 2 zeigt eine Vorrichtung, die nicht im Rahmen der Erfindung liegt. Die Maske 2 (Ring) wird von einer Scheibe 8 getragen. Der Wafer W wird an seiner der Maske abgewandten Oberfläche Wb durch einen rotierbaren Vakuumträger 13 (vacuum-chuck) gehalten. Dies hat den Vorteil, dass weder der Waferrand noch die der Maske zugewandte Waferoberfläche Wf berührt werden. Sowohl der den Wafer W haltende Träger 13 als auch die Maske 2 können um die selbe Achse A gedreht werden, der Träger in Richtung Rw und die Maske in Richtung Rm. Geschieht dies mit der selben Umdrehungsgeschwindigkeit und in die selbe Richtung so werden Maske und Wafer relativ zueinander nicht bewegt (Rw = Rm). Träger 13 und Maske 2 sind über ein Distanzveränderungsmittel 5 mit einander verbunden und werden durch dieses von einander weg und auf einander zu bewegt (Pfeile L). Dieses Distanzveränderungsmittel 5 kann z.B. ein Pneumatikzylinder oder eine Spindel sein. Mit Hilfe dieses Distanzveränderungsmittels 5 kann der Spalt 15 zwischen Wafer und Maske exakt eingestellt werden, daher stellt es gleichzeitig ein Distanzmittel dar. Durch eine Düse 7 wird eine Flüssigkeitsmenge 20 unmittelbar beim Waferrand auf die Maske 2 aufgebracht. Die Flüssigkeit wird sodann von dem kapillarartigen Spalt 15 eingezogen.

Fig. 3 zeigt eine zweite Ausführungsform. Die Vorrichtung 1 besteht aus einem Badbehälter 27 in dem sich ein topfförmiger Träger 24 befindet. Der Raum 23 innerhalb des Trägers ist gegen das zwischen Träger und Badbehälter befindlichen Bad 26 abgedichtet. Der Träger 24 kann mit Hilfe des Hebemechanismus aus dem Bad 26 gehoben werden. Der obere Rand des Trägers hat die Form eines Ringes 2 der die Maske darstellt, mit einer zum Wafer W zugewandten und zu dessen Oberflächen Wf planparallelen Fläche. Auf diesem Ring 2 (Maske) befinden sich Stifte 3 mit Kerben, die den Wafer in definiertem Abstand zur Maske halten, wodurch sich ein Spalt 15 ausbildet. Der Träger 2 mit dem darauf befindlichen Wafer W wird so weit in das Bad abgesenkt (L1), dass sich der Flüssigkeitsspiegel etwas oberhalb des Ringes befindet, sodass der Waferrand benetzt wird. Die Flüssigkeit wird durch Kapillarkräfte in den Spalt 15 zwischen Wafer und Maske eingezogen. Um ein Eindringen von Flüssigkeit in den Raum 23 innerhalb des Trägers infolge von darin befindlichen Unterdrucks zu verhindern, steht der Raum über das Rohr 25 mit der Umgebung in Verbindung. Auch kann über dieses Rohr 25 leichter Überdruck in dem Raum 23 innerhalb des Trägers aufgebaut werden, wird der Träger wieder aus dem Bad gehoben (L1 ). Nach der Flüssigkeitsbehandlung wird die im Spalt 15 befindliche Flüssigkeit mit Hilfe von stärkerem Überdruck, aufgebaut durch ein durch das Rohr 25 zugeführtes Gas, radial nach außen gedrückt. Auch kann der Spalt 15 mit einem Distanzveränderungsmittel 5 vergrößert werden. Hier sind vier auf und ab bewegliche Stifte 5 gezeigt, die den Wafer innerhalb der Maske 2 an seiner der Maske zugeordneten Fläche berühren und senkrecht anheben können (L2).

Fig. 4 zeigt eine dritte Ausführungsform. Die Vorrichtung besteht aus einem Bad 14, in dem sich die Behandlungsflüssigkeit befindet und das auf und ab bewegt werden kann (Pfeile L1) und einem Träger 11. Der Träger 11 besteht aus einem Grundkörper 4 und einem unten angeformten Ring 2. Stifte 3 mit Kerben, die auf dem Ring 2 unten angebracht sind, halten den Wafer W umfangsseitig, und zwar in definiertem Spaltabstand zum Ring 2, sodass der Wafer in waagrechter Position unten am Träger hängt. Der Träger 11 samt Wafer W wird in das Bad 27 so weit eingetaucht, dass der Flüssigkeitsspiegel den Ring 2 benetzt, und somit die dem Ring abgewandte Oberfläche Wb des Wafers und der umfangsseitige Waferrand vollständig benetzt wird. Die Flüssigkeit dringt in den Spalt zwischen Wafer und Ring ein. Der Träger 11 wird nach der Behandlung aus dem Bad gehoben. Ein innerhalb des Trägers montierter Vakuumgreifer (vacuum-pickup) 5 wird nach unten bewegt, sodass er den Wafer an der der Maske zugewandten Oberfläche Wf des Wafers berührt und ansaugt. Danach wird der Wafer mit dem Greifer weiter nach unten bewegt und so die Kapillarkraft wodurch die Flüssigkeit innerhalb des Spaltes 15 gehalten wird überwunden. Durch Rotation des Greifers können eventuell auf dem Wafer verbleibende Flüssigkeitsreste abgeschleudert werden.

Fig. 5 zeigt eine Ausführungsform. Die Vorrichtung besteht aus einem Träger 11, der einen Grundkörper 4 und einem Ring 2, der über die Abstandskörper 41 beabstandet zum Grundkörper auf diesem befestigt ist. Der Ring ist über die Abstandsteile 41 Auf dem Ring 2 sind Stifte 53 befestigt, die bezogen auf die Rotationsachse A des Trägers 11 radial nach außen bewegt werden können und den Wafer W umfangsseitig umschließen können. Die Stifte 53 haben die Form kleiner Zylinder mit ihren Achsen senkrecht zur Oberfläche des Wafers. In den Grundkörper 4 sind Gaskanäle 44 und 45 eingearbeitet, die in Gasdüsen 46 und 49 münden gegen die dem Träger 11 zugewandte Oberfläche des Wafers gerichtet sind. Die Düsen 46 und 49 sind schräg nach außen gestellt, wobei die weiter innen liegenden Düsen 49 weniger schräg gestellt sind als die weiter außen liegenden Düsen 46, d.h. der austretende Gasstrom G1 der weiter außen liegenden Düsen 46 trifft in einem flacheren Winkel auf die Waferoberfläche auf, als der austretende Gasstrom G2 der weiter innen liegenden Düsen. Der Abstand des Grundkörpers 4 zum Wafer W ist im Bereich 48 zwischen den inneren und äußeren Düsen 49 und 46 kleiner als im Bereich 47 außerhalb der äußeren Düsen 46. Sowohl die innen liegenden Düsen 49 als auch die außen liegenden Düsen 46 können wahlweise entweder eine Vielzahl kreisförmig angeordnete Düsen sein, oder die Form von Ringdüsen besitzen.

Diese Vorrichtung kann auf im wesentlichen zwei verschiedene Arten betrieben werden. Bei der ersten Betriebsart können der äußere Gasstrom G1 und der innere Gasstrom G2 getrennt von einander ein und ausgeschaltet werden. Ist nur der erste Gasstrom G1 eingeschalten so strömt Gas nur über den Bereich 47. Der Wafer W wird nur leicht angehoben, wodurch sich ein kleiner kapillarartiger Spalt 15 zwischen Maske 2 und Wafer W ausbildet. Wird in diesem ersten Betriebszustand nun Flüssigkeit, wie in der Beschreibung zu Fig. 1 beschrieben, aufgetragen, so wird diese in den Spalt 15 eingezogen. Wird nun zusätzlich oder statt des Gasstromes G1 der Gasstrom G2 eingeschalten so strömt Gas nicht nur über den Bereich 47 außerhalb der äußeren Düsen 46, sondern auch über den Bereich 48 zwischen den äußeren und den inneren Düsen. Durch diesen zweiten Betriebszustand wird der Wafer W etwas angehoben, dargestellt durch die gepunktete Linie. Der Waferrand gleitet dabei entlang der Zylinderfläche der Stifte 53. Dieses leichte Anheben des Wafers reicht aus dafür, dass die Flüssigkeit im Spalt 15 zwischen Maske und Wafer nicht mehr durch Kapillarkräfte gehalten wird. Die Flüssigkeit kann aus diesem Bereich entfernt werden, was durch den Gasstrom geschieht, d.h. die Tropfen werden radial nach außen hin weggeblasen. Unterstützt kann die Entfernung der Flüssigkeit dadurch werden, dass der gesamte Träger 11 und mit ihm der Wafer rotiert. Zusätzlich kann durch eine Düse, welche durch die Flüssigkeitsleitung 28 gespeist wird, Spülflüssigkeit durch den Grundkörper 4 auf die dem Träger zugewandte Waferoberfläche geführt werden, wodurch die im Spalt 15 befindliche Flüssigkeit zusätzlich verdrängt wird. Diese Spülflüssigkeit muss ihrerseits selbst verständlich auch wieder entfernt werden.

Bei der zweiten Betriebsart werden beide Gasströme G1 und G2 gemeinsam geschaltet. In einem ersten Betriebszustand strömt weniger Gas als in einem zweiten Betriebszustand, wodurch der Wafer im zweiten Betriebszustand eine Lage einnimmt, bei der sein Abstand zu der Maske 2 größer ist, als im ersten Betriebszustand. Der Abstand des Wafers W zur Maske 2 im ersten Betriebszustand ist z.B. 0,5 mm und im zweiten 0,8 mm.

Anhand der Fig. 6-8 soll nun die Betriebsweise einer erfindungsgemäßen Vorrichtung beschrieben werden, wobei von der Ausführungsform der Fig. 1 ausgegangen wird. Zuerst wird der Wafer W in die Nähe der Maske 2 gebracht, wodurch sich der Spalt 15 ausbildet. Der definierte Abstand zwischen der Maske 2 und dem Wafer wird durch Distanzmittel gewährleistet, hier die Stifte 3 (Fig. 7) mit Kerben. Nun wird Flüssigkeit entweder auf die der Maske abgewandte Waferoberfläche Wb oder direkt an den Waferrand aufgetragen. Die Flüssigkeit tritt zum Teil in den Spalt 15 ein (F2). Der überschüssige Teil der Flüssigkeit F1 rinnt ab bzw. wird wenn die Maske und/oder der Wafer rotieren abgeschleudert. Die Flüssigkeit kann nicht weiter nach innen rinnen als die innere Kontur der Maske 2 ist, d.h. sie dringt nur bis zum Punkt P vor. Der Abstand a1 zwischen der Maske 2 und dem Wafer wird so klein gewählt, dass die Flüssigkeit durch Kapillarkräfte innerhalb des Spaltes 15 gehalten wird, und dort die Waferoberfläche behandelt. Ein Hebemechanismus 5 tritt nun in Kontakt mit der der Maske 2 zugewandten Waferoberfläche Wf, die Stifte 3 werden nun geöffnet (B) und der Hebemechanismus 5 hebt den Wafer soweit an, dass der Flüssigkeitsfilm im Spalt 15 reißt und nur mehr Tropfen 16 auf der Maske und/oder der Waferoberfläche bleiben. Diese Tropfen 16 können nun abgespült, abgeblasen und/oder abgeschleudert werden.

## Patentansprüche

1. Vorrichtung zur Flüssigkeitsbehandlung eines definierten, Abschnitts eines scheibenförmigen Gegenstandes (W), insbesondere eines Wafers, bestehend aus
1.1 Haltemittel (3, 53) zum Halten des scheibenförmigen Gegenstandes
1.2 einer Maske (2) die in Form und Größe dem zu behandelnden Bereich des definierten Abschnittes der mit der Flüssigkeit behandelt werden soll entspricht,
1.3 Distanzmittel (3, 31, 45, 41), die die Maske und den scheibenförmigen Gegenstand in einem solchen definierten geringen Abstand zueinander halten, dass Flüssigkeit zwischen der Maske und dem definierten Bereich des scheibenförmigen Gegenstandes durch Kapillarkräfte gehalten werden kann,
1.4 Distanzveränderungsmittel (5, 44, 49), die den Abstand (a1) zwischen der Maske und dem scheibenförmigen Gegenstand zueinander so vergrößern (a2) können, dass Flüssigkeit, die sich zwischen Maske und scheibenförmigen Gegenstand befindet nicht mehr durch Kapillarkräfte gehalten wird, wobei die Distanzmittel von den Distanzveränderungsmitteln verschieden sind.

2. Vorrichtung nach Anspruch 1, bei der die Maske (2) die Form eines Ringes besitzt.

3. Vorrichtung nach Anspruch 2, bei der der Ring einen Innendurchmesser besitzt, der kleiner ist als der Außendurchmesser des scheibenförmigen Gegenstandes, und einen Außendurchmesser, der mindestens gleich groß ist wie der Außendurchmesser des scheibenförmigen Gegenstandes.

4. Vorrichtung nach Anspruch 1, bei der die Distanzmittel die Maske und den scheibenförmigen Gegenstand in einem Abstand (a1) von 0,05 bis 1 mm halten.

5. Vorrichtung nach Anspruch 1, wobei das Distanzmittel aus Greifelementen (3, 53) besteht, die in direktem Kontakt mit dem scheibenförmigen Gegenstand sind und direkt oder indirekt mit der Maske (2) verbunden sind.

6. Vorrichtung nach Anspruch 1, bei der Maske und Haltemittel relativ zueinander bezüglich einer Rotation um eine senkrecht auf die Maske stehende Achse (A) unbeweglich sind.

7. Vorrichtung nach Anspruch 1, wobei das Distanzmittel aus einer Gaszuführeinrichtung (45, 46) besteht, die direkt oder indirekt (41) mit der Maske (2) verbunden ist und gegen den scheibenförmigen Gegenstand gerichtet ist, wodurch der scheibenförmigen Gegenstand auf einem Gaspolster gehalten werden kann.

8. Vorrichtung nach Anspruch 1, mit im wesentlichen senkrecht zu einer Hauptoberfläche des scheibenförmigen Gegenstandes angeordneten, die Position des scheibenförmigen Gegenstandes umfangsseitig begrenzenden Führungselementen (3, 53).

9. Vorrichtung Anspruch 1, bei der die Haltemittel aus Führungselementen und einer Gaszuführeinrichtung (53, 45, 46) bestehen.

10. Vorrichtung nach Anspruch 1, bei der das Distanzveränderungsmittel aus einer Gaszuführeinrichtung (44, 49) besteht, die direkt oder indirekt mit der Maske verbunden ist und gegen eine Hauptoberfläche (Wf) des scheibenförmigen Gegenstandes gerichtet ist, wodurch der scheibenförmigen Gegenstand auf einem Gaspolster gehalten werden kann.

11. Vorrichtung nach Anspruch 1, bei der die Haltemittel in Rotation (R) versetzt werden können.

12. Vorrichtung nach Anspruch 1 mit einer Flüssigkeitsleitung (28), die auf die der Maske zugewandte Oberfläche des scheibenförmigen Gegenstandes gerichtet ist.

13. Verfahren zur Flüssigkeitsbehandlung eines definierten Abschnitts eines scheibenförmigen Gegenstandes (W) mit den folgenden aufeinanderfolgenden Schritten:
13.1 der scheibenförmige Gegenstand (W) wird in die Nähe einer Maske (2) gebracht, die in Form und Größe dem zu behandelnden Bereich des definierten Abschnittes der mit der Flüssigkeit behandelt werden soll entspricht, wobei sich ein Spalt (15) zwischen scheibenförmigem Gegenstand (W) und der Maske (2) ausbildet und der Abstand a1 zwischen der Maske (2) und scheibenförmigem Gegenstand (W) wird so klein gewählt, dass die Flüssigkeit durch Kapillarkräfte innerhalb des Spaltes (15) gehalten wird;
13.2 Einbringen von Flüssigkeit in den Spalt zwischen Wafer (W) und Maske (2);
13.3 Vergrößern des Abstandes a1 zwischen scheibenförmigen Gegenstand und Maske bis der Flüssigkeitsfilm im Spalt (15) reißt;
13.4 Entfernen der Flüssigkeitstreste von der Waferoberfläche.

14. Verfahren nach Anspruch 13, wobei die Flüssigkeit auf die der Maske abgewandte Seite des Wafers aufgebracht wird.

15. Verfahren nach Anspruch 13, wobei der scheibenförmige Gegenstand während der Flüssigkeitsbehandlung rotiert.

16. Verfahren nach Anspruch 13, wobei die Flüssigkeitsreste abgespült werden.

17. Verfahren nach Anspruch 13, wobei die Flüssigkeitsreste abgeblasen werden.

18. Verfahren nach Anspruch 13, wobei die Flüssigkeitsreste abgeschleudert werden.

## Claims

1. Apparatus for liquid treatment of a defined section a disc-shaped article (W), especially a wafer, consisting of
1.1 holder means (3, 53) for holding the disc-shaped article
1.2 a mask (2) which corresponds in shape and size to the region of the defined section which is to be treated with the liquid,
1.3 spacer means (3, 31, 45, 41) which hold the mask and the disc-shaped article at such a defined small spacing from one another that liquid can be retained between the mask and the defined region of the disc-shaped article by capillary forces,
1.4 spacing altering means (5, 44, 49) which can so enlarge (a2) the spacing (a1) between the mask and the disc-shaped article that liquid which is present between the mask and the disc-shaped article is no longer retained by capillary forces, the spacer means being different from the spacing altering means.

2. Apparatus according to claim 1, in which the mask (2) has the shape of a ring.

3. Apparatus according to claim 2, in which the ring has an inner diameter which is smaller than the outer diameter of the disc-shaped article and an outer diameter which is at least the same size as the outer diameter of the disc-shaped article.

4. Apparatus according to claim 1, in which the spacer means keep the mask and the disc-shaped article at a spacing (a1) of 0.05 to 1 mm.

5. Apparatus according to claim 1, wherein the spacer means consist of gripper elements (3, 53) which are in direct contact with the disc-shaped article and are connected directly or indirectly to the mask (2).

6. Apparatus according to claim 1, in which the mask and holder means are immovable relative to one another in relation to rotation about an axis (A) perpendicular to the mask.

7. Apparatus according to claim 1, wherein the spacer means consist of a gas feed device (45, 46) which is connected directly or indirectly (41) to the mask (2) and is directed against the disc-shaped article, whereby the disc-shaped article can be held on a gas cushion.

8. Apparatus according to claim 1, with guide elements (3, 53) arranged substantially perpendicular to a major surface of the disc-shaped article and bounding the position of the disc-shaped article at the periphery.

9. Apparatus according to claim 1, in which the holder means consist of guide elements and a gas feed device (53, 45, 46).

10. Apparatus according to claim 1, wherein the spacing altering means consist of a gas feed device (44, 49) which is connected directly or indirectly to the mask and is directed against a major surface (Wf) of the disc-shaped article, whereby the disc-shaped article can be held on a gas cushion.

11. Apparatus according to claim 1, wherein the holder means can be set in rotation (R).

12. Apparatus according to claim 1, with a liquid line (28) which is directed on to the surface of the disc-shaped article facing the mask.

13. A method of liquid treatment of a defined section of a disc-shaped article (W) with the following sequential steps:
13.1 the disc-shaped article (W) is brought into the vicinity of a mask (2) which corresponds in shape and size to the region of the defined section to be treated with the liquid, wherein a gap (15) is formed between the disc-shaped article (W) and the mask (2) and the spacing a1 between the mask (2) and disc-shaped article (W) is made so small that the liquid is held within the gap (15) by capillary forces;
13.2 introducing liquid into the gap between wafer (W) and mask (2);
13.3 increasing the spacing a1 between disc-shaped article and mask until the liquid film in the gap (15) ruptures;
13.4 removing the liquid residues from the wafer surface.

14. A method according to claim 13, wherein the liquid is applied on side of the wafer facing away from the mask.

15. A method according to claim 13, wherein the disc-shaped article rotates during the liquid treatment.

16. A method according to claim 13, wherein the liquid residues are rinsed off.

17. A method according to claim 13, wherein the liquid residues are blown off.

18. A method according to claim 13, wherein the liquid resides are spun off.

## Revendications

1. Dispositif pour le traitement liquide d'une portion définie d'un objet (W) en forme de plaquette, en particulier d'une pastille, comprenant :
1.1. des moyens de retenue (3, 53) pour tenir l'objet en forme de plaquette,
1.2. un masque (2) dont la forme et les dimensions correspondent à la zone de la portion définie devant être traitée avec le liquide,
1.3. des moyens d'écartement (3, 31, 45, 41) qui maintiennent le masque et l'objet en forme de plaquette à une faible distance donnée l'un de l'autre, telle que le liquide soit retenu par les forces de capillarité entre le masque et la zone définie de l'objet en forme de plaquette,
1.4. des moyens de modification de l'écartement (5, 44, 49) qui peuvent augmenter la distance (a1) entre le masque et l'objet en forme de plaquette de telle sorte que le liquide qui se trouve entre le masque et ledit objet en forme de plaquette ne soit plus retenu par les forces de capillarité, les moyens d'écartement étant distincts des moyens de modification de l'écartement.

2. Dispositif selon la revendication 1, dans lequel le masque (2) a la forme d'un anneau.

3. Dispositif selon la revendication 2, dans lequel l'anneau a un diamètre intérieur qui est inférieur au diamètre extérieur de l'objet en forme de plaquette et un diamètre extérieur qui est au moins égal au diamètre extérieur de l'objet en forme de plaquette.

4. Dispositif selon la revendication 1, dans lequel les moyens d'écartement maintiennent le masque et l'objet en forme de plaquette à une distance mutuelle (a1) de 0,05 à 1 mm.

5. Dispositif selon la revendication 1, dans lequel le moyen d'écartement est formé d'éléments de préhension (3, 53), qui sont en contact direct avec l'objet en forme de plaquette et sont liés de manière directe ou indirecte au masque (2).

6. Dispositif selon la revendication 1, dans lequel le masque et les moyens de retenue sont fixes l'un par rapport à l'autre en ce qui concerne une rotation autour d'un axe (A) perpendiculaire au masque.

7. Dispositif selon la revendication 1, dans lequel les moyens d'écartement sont formés d'un dispositif d'amenée de gaz (45, 46) qui est lié de manière directe ou indirecte (41) au masque (2) et est dirigé sur l'objet en forme de plaquette, l'objet en forme de plaquette étant ainsi tenu sur un coussin de gaz.

8. Dispositif selon la revendication 1, comportant des éléments de guidage (3, 53) qui sont disposés essentiellement perpendiculairement à une surface principale de l'objet en forme de plaquette et délimitent extérieurement la position dudit objet en forme de plaquette.

9. Dispositif selon la revendication 1, dans lequel les moyens de retenue comprennent des éléments de guidage et un dispositif d'amenée de gaz (53, 45, 46).

10. Dispositif selon la revendication 1, dans lequel le moyen de modification de l'écartement est formé d'un dispositif d'amenée de gaz (44, 49) qui est lié de manière directe ou indirecte au masque et est dirigé sur une surface principale (Wf) de l'objet en forme de plaquette, l'objet en forme de plaquette étant ainsi tenu sur un coussin de gaz.

11. Dispositif selon la revendication 1, dans lequel le moyen de retenue peut être mis en rotation.

12. Dispositif selon la revendication 1, comprenant une conduite de liquide (28) qui est dirigée sur la surface principale de l'objet en forme de plaquette tournée vers le masque.

13. Procédé pour le traitement liquide d'une portion définie d'un objet (W) en forme de plaquette, comprenant les étapes suivantes:
13.1. on place l'objet (W) en forme de plaquette dans le voisinage d'un masque (2), dont la forme et les dimensions correspondent à la zone de la portion définie devant être traitée avec le liquide, une fente (15) étant formée entre l'objet (W) en forme de plaquette et le masque (2) et la distance (a1) entre le masque (2) et l'objet (W) en forme de plaquette étant choisie suffisamment petite pour que le liquide soit retenu à l'intérieur de la fente (15) par les forces de capillarité ;
13.2. on introduit du liquide dans la fente entre la plaquette (W) et le masque (2) ;
13.3. on augmente la distance (a1) entre l'objet en forme de plaquette et le masque jusqu'à ce que le film de liquide dans la fente (15) se déchire ;
13.4. on élimine les restes de liquide à la surface de la plaquette.

14. Procédé selon la revendication 13, dans lequel on applique le liquide sur la face de la plaquette éloignée du masque.

15. Procédé selon la revendication 13, dans lequel l'objet en forme de plaquette tourne pendant le traitement liquide.

16. Procédé selon la revendication 13, dans lequel on élimine par rinçage les restes de liquide.

17. Procédé selon la revendication 13, dans lequel on élimine par soufflage les restes de liquide.

18. Procédé selon la revendication 13, dans lequel on élimine par centrifugation les restes de liquide.
